## Europäisches Patentamt
## European Patent Office
## Office européen des brevets

(19)

(11) Veröffentlichungsnummer: **0 029 920**
**B1**

(12) **EUROPÄISCHE PATENTSCHRIFT**

(45) Veröffentlichungstag der Patentschrift:
**20.07.83**

(51) Int. Cl.³: **H 03 K 5/13**

(21) Anmeldenummer: **80106637.4**

(22) Anmeldetag: **29.10.80**

(54) **Integrierte Verzögerungsschaltung.**

(30) Priorität: **30.11.79 US 99148**

(43) Veröffentlichungstag der Anmeldung:
**10.06.81 Patentblatt 81/23**

(45) Bekanntmachung des Hinweises auf die Patenterteilung:
**20.07.83 Patentblatt 83/29**

(84) Benannte Vertragsstaaten:
**DE FR GB IT NL SE**

(56) Entgegenhaltungen:
**DE-A-2 601 572**
**US-A-3 887 823**

,,IBM Technical Disclosure Bulletin'', Bd. 16, Nr. 5, Oktober 1973, S. 1398-1399, New York, U.S.A., P.H. Hernandez et al.: ,,Delayed single-shot''.
,,IBM Technical Disclosure Bulletin'', Bd. 11, Nr. 1, Juni 1968, S. 45, New York, U.S.A., H.T. Hilton: ,,Voltage variable delay line''.

(73) Patentinhaber: **International Business Machines Corporation, Old Orchard Road, Armonk, N.Y. 10504 (US)**

(72) Erfinder: **Houghton, Russell James, 40 Pleasant Street, Essex Jct., VT 05452 (US)**

(74) Vertreter: **Böhmer, Hans Erich, Dipl.-Ing., Schönaicher Strasse 220, D-7030 Böblingen (DE)**

EP 0 029 920 B1

Integrierte Verzögerungsschaltung

Die Erfindung betrifft eine integrierte Verzögerungsschaltung gemäss dem Oberbegriff von Anspruch 1 für lange zeitliche Verzögerungen in mit bipolaren Transistoren ausgerüsteten Schaltungen.

Verzögerungsschaltungen aller Art sind seit langem bekannt, doch lassen sich Schaltungen zum Erzielen grosser Verzögerungen in bipolarer Schaltungstechnik nur mit Schwierigkeiten verwirklichen und erfordern komplizierte Schaltungen oder Verfahren.

Die US-Patentschrift Nr. 3466469 offenbart eine Schaltung mit einem als zeitbestimmendes Glied wirkenden Kondensator, der an einem PNP-NPN-Transistorpaar angeschlossen ist, wobei Mittel für eine lineare Entladung des Kondensators vorgesehen sind. Die Rückkopplungswirkung des Transistorpaares liefert eine Anzeige für den Zeitablauf.

In „IBM Technical Disclosure Bulletin", Bd. 11, Nr. 1, Juni 1968, S. 45 ist die Ausnutzung der für den Abtransport der im Basisbereich eines Transistors gespeicherten Ladungsträger benötigten Zeit für die Impulsverzögerung beschrieben.

Die US-Patentschrift Nr. 3887823 zeigt eine Impulsverzögerungsschaltung mit einem Differentialverstärker und mit einem aus Widerstand und Kondensator aufgebauten Zeitkonstantenglied, das an der Basiselektrode des einen der beiden Verstärkertransistoren angeschlossen ist. Die Schaltung verwendet einen Amplitudendetektor, der dann einen Schaltvorgang auslöst, wenn die Spannungs- oder Stromamplitude eines Entladevorganges einen Bezugswert über- oder unterschreitet. Eine ähnliche Anordnung ist auch aus „IBM Technical Disclosure Bulletin", Bd. 16, Nr. 5, Oktober 1973, S. 1398 und 1399 bekannt.

Aufgabe der Erfindung ist es, eine verbesserte Verzögerungsschaltung für integrierte Schaltungstechnik zu schaffen, die nur eine sehr kleine Fläche auf der Oberfläche des Halbleitersubstrats benötigt und wenig Leistung verbraucht. Insbesondere soll durch die Erfindung eine Verzögerungsschaltung mit steuerbarer, langer Verzögerung geschaffen werden, die sich für bipolare Schaltungstechnik eignet und dabei die Zeitkonstante eines Transistors als das die Verzögerung bestimmende Element benutzt, insbesondere die sehr grosse Zeitkonstante eines lateralen PNP-Transistors.

Erfindungsgemäss wird also eine integrierte Verzögerungsschaltung geschaffen, die einen bipolaren Transistor enthält, mit daran angeschlossenen Schaltmitteln zur Erzeugung einer in dem bipolaren Transistor gespeicherten Ladung zur Aufrechterhaltung des Transistorstromes sowie mit an der Basiselektrode des Transistors angekoppelten Schaltern, die bei Betätigung praktisch jeden Stromfluss von der Basis des Transistors durch den Schalter hindurch unterbinden. Dieser Schalter ist dadurch gekennzeichnet, dass er eine viel kleinere gespeicherte Ladung zu halten vermag als der Transistor. Wenn der Schalter betätigt wird, und den Stromkreis unterbricht, dann nimmt der zwischen Emitter und Kollektor des Transistors fliessende Strom exponentiell ab. Führt man diesen Transistorstrom einem Stromamplitudendetektor oder einem Eingang einer Vergleichsstufe zu, während der andere Eingang der Vergleichsstufe durch einen Bezugsstrom angesteuert wird, dann wird ein Ausgangsimpuls erzeugt, der eine vom Zeitpunkt der Betätigung des Schalters ausgehende, genau gesteuerte zeitliche Verzögerung aufweist. In einer Ausführungsform der Erfindung wird als Transistor vorzugsweise ein PNP-Transistor verwendet, der in der Lage ist, in seiner Basiszone eine hohe gespeicherte Ladung aufrechtzuerhalten, und damit grosse zeitliche Verzögerungen liefert, während als Schalter eine Schottky-Diode verwendet wird, die wesentlich kleinere gespeicherte Ladungen zu halten vermag als der PNP-Transistor.

Die Erfindung wird nunmehr anhand eines Ausführungsbeispiels in Verbindung mit den beigefügten Zeichnungen im einzelnen näher erläutert.

In den Zeichnungen zeigen

Fig. 1 ein vereinfachtes Schaltbild, teilweise als Blockschaltbild, einer in Ausführungsform der Erfindung;

Fig. 2 eine Schnittansicht durch ein Halbleitersubstrat, mit einem PNP-Transistor für einen Einsatz in einer Schaltung gemäss Fig. 1;

Fig. 3 ein Impulsdiagramm zur Darstellung von Spannungs- und Stromverlauf in der Ausführungsform gemäss Fig. 1;

Fig. 4 ein ausführliches Schaltbild einer integrierten Verzögerungsschaltung gemäss der Erfindung, und

Fig. 5 die in der Schaltung gemäss Fig. 4 auftretenden Spannungen und Ströme.

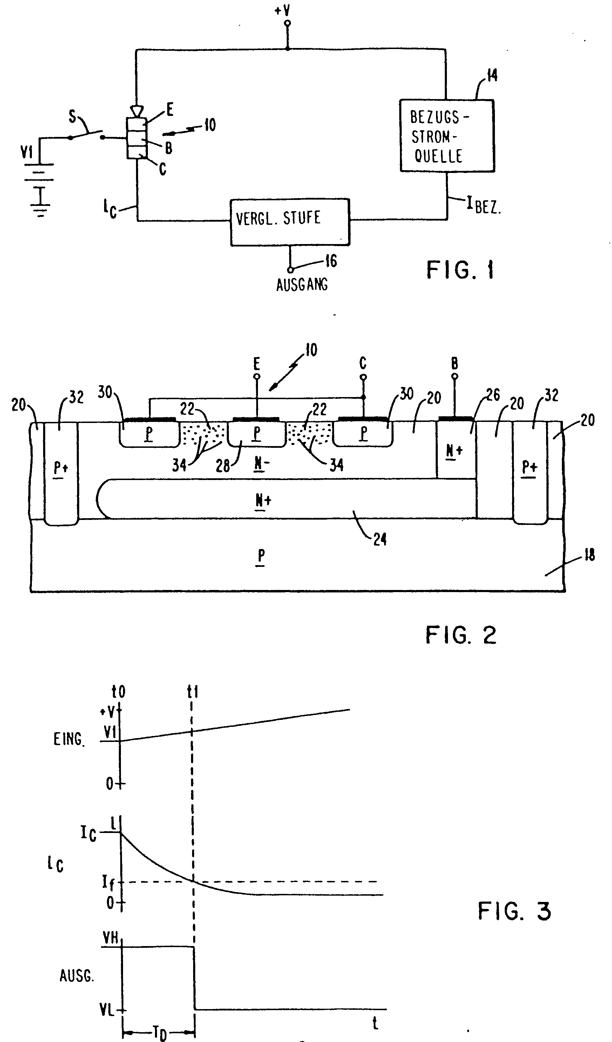

In Fig. 1 ist, teilweise als Blockschaltbild, eine Ausführungsform der integrierten Verzögerungsschaltung gemäss der Erfindung dargestellt. Die Schaltung enthält einen PNP-Transistor, dessen Emitterelektrode E an einer Vorspannungsquelle +V und dessen Kollektorelektrode C an einer Eingangsklemme einer Vergleichsstufe 12 angeschlossen ist, während die Basiselektrode B über einen Schalter S an eine Spannungsquelle V1 angeschlossen ist, deren Spannung vorzugsweise gleich +V, weniger der Basisemitterspannung $V_{BE}$ in Durchlassrichtung des Transistors 10, ist. Eine Bezugsstromquelle 14 liefert einen Bezugsstrom $I_{BEZ}$ und ist zwischen die Betriebsspannungsquelle +V und die andere Eingangsklemme der Vergleichsstufe 12 eingeschaltet. Eine Ausgangsklemme der Vergleichsstufe 12 ist bei 16 angedeutet. In Fig. 2 ist eine Schnittansicht des in Fig. 1 gezeigten Transistors dargestellt, bestehend aus einem P-leitenden Substrat 18, unterhalb einer N-leitenden Epitaxialschicht 20, in der die Basiszone 22 des Transistors liegt.

Der Kontaktanschluss an die Basiszone 22 wird über eine N+-leitende, vergrabene Zone 24 und über eine N+-leitende, durchgehende Zone 26 hergestellt. P-leitende Emitter- und Kollektorzonen des Transistors sind bei 28 bzw. 30 gezeigt, wobei die Kollektorzone 30 die Emitterzone 28 und die Basiszone 22 umschliesst.

Eine P+-leitende Isolationszone 32 umgibt den Transistor 10 und erstreckt sich bis auf das P-leitende Substrat 18.

Die Arbeitsweise der integrierten Verzögerungsschaltung gemäss Fig. 1 lässt sich am besten anhand des in Fig. 3 dargestellten Impulsdiagramms verstehen. Wenn der Schalter S geschlossen ist, liegt eine Spannung V1 an der Basiselektrode B des Transistors 10 und ein durch den Transistor 10 hindurchfliessender Strom $I_c$ erreicht seinen stabilen Zustand mit dem Wert $I_c$, der von der Kollektorzone C nach einer Eingangsklemme der Vergleichsstufe 12 fliesst. Während dieses stabilen Zustandes wird in bekannter Weise eine Ladung 34, die in Fig. 2 angedeutet ist, in der Basiszone 22 gespeichert. Diese gespeicherte Ladung in der Basiszone 22 kann als eine in einer Diffusionskapazität gespeicherte Ladung betrachtet werden. Wird der Schalter S zum Zeitpunkt $t_0$ geöffnet, d.h. wenn die von der Spannungsquelle V1 an der Basiselekt rode liegende Spannung abgeschaltet wird, dann wird der durch den Transistor 10 fliessende Strom durch die in der Basiszone 22 gespeicherte Ladung 34, jedoch mit ständig abnehmender Stromstärke, entsprechend der in der Basiszone 22 verbleibenden Ladung aufrechterhalten sowie die Spannung an der Basiselektrode B in Richtung auf die Spannung +V zunimmt. Der Strom $I_c$ nimmt exponentiell ab, wie es in Fig. 3 angedeutet ist und folgt der Beziehung $e^{-t/\tau}$, wobei t die Zeit und $\tau$ die Zeitkonstante des Transistors ist, mit $\tau \propto \beta/f_T$, wobei $\beta$ die Stromverstärkung und $f_T$ die Grenzfrequenz des Transistors ist. Man sieht, dass es für diese Schaltung wünschenswert ist, zur Erhöhung der Verzögerungszeiten einen Transistor 10 mit einer niedrigen Grenzfrequenz oder einer grossen Ladungsspeicherkapazität zu haben. Ein Transistor mit einer niedrigen Grenzfrequenz oder einer hohen Ladungsspeicherkapazität kann man leicht in Form eines lateralen PNP-Transistors aufbauen, wie er in Fig. 2 dargestellt ist. Die im Transistor 10 gespeicherte Ladung kann man dadurch erhöhen, dass man beispielsweise die Breite der Basiszone 22 erhöht.

Durch geeignete Auswahl der Schaltungsparameter in der Vergleichsstufe 12 kann man erreichen, dass die Ausgangsspannung an der Ausgangsklemme 16 ihren niedrigeren Wert VL bei einem vorbestimmten Strom längs der Kurve $I_c$ in Fig. 3, wie z.B. bei $I_f$ zum Zeitpunkt t1 erreicht, wodurch man die Verzögerungszeit $T_d$ erhält.

Es sei darauf hingewiesen, dass durch einen Schalter S an der Basiselektrode B des Transistors 10 mit keinem oder nur ganz geringem Leckstrom oder mit nur einer ganz kleinen Kapazität bei offenem Schalter S nicht beeinträchtigt wird, so dass der Anfangswert von $I_c$ in Beziehung zu $I_f$ beibehalten wird, wodurch sich die zeitliche Verzögerung $T_D$ mit grösserer Genauigkeit einstellen lässt.

Man sieht, dass durch Isolieren der während des eingeschwungenen Betriebszustandes des Transistors in der Basiszone eingespeicherten Ladung von dem Teil der Schaltung, der an der Basiszone angeschlossen sein kann, die ursprünglich in dem Transistor selbst eingespeicherte Ladung als bestimmendes Element für die Gesamtverzögerung der Verzögerungsschaltung benutzt werden kann.

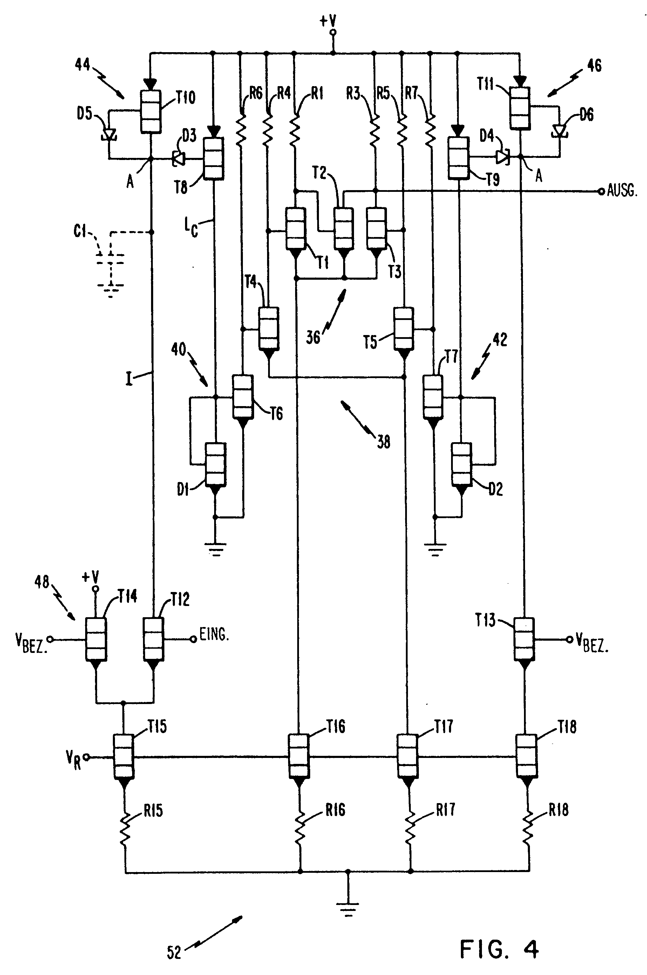

Fig. 4 zeigt eine integrierte Verzögerungsschaltung gemäss der Erfindung im einzelnen. Diese Schaltung enthält eine Verriegelungsschaltung 36 mit den Transistoren T1, T2 und T3 und einem Widerstand R1 zur Verbindung zwischen dem Transistor T1 und einer Spannungsquelle +V sowie einen Widerstand R3 zur Verbindung zwischen den Transistoren T2 und T3 und der Spannungsquelle +V. Eine Ausgangsklemme ist an die Kollektorelektroden der Transistoren T2 und T3 angeschlossen. Ein Differentialverstärker 38 enthält Transistoren T4 und T5, die über Widerstände R4 bzw. R5 an der Spannungsquelle +V angeschlossen sind. Ein erster Stromverstärker 40 enthält einen Transistor T6 und eine Diode D1 sowie einen Widerstand R6, der den Transistor T6 mit der Spannungsquelle +V verbindet. Ein zweiter Stromverstärker 42 enthält einen Transistor T7 und eine Diode D2 sowie einen Widerstand R7, der den Transistor T7 mit der Spannungsquelle +V verbindet. Die Verriegelungsschaltung 36, der Differentialverstärker 38 und die beiden Stromverstärker bilden eine Vergleichsstufe, für die an sich auch eine andere bekannte Vergleichsstufe eingesetzt werden könnte. Ein erster, die zeitliche Verzögerung bestimmender PNP-Transistor T8 ist zwischen der Basiselektrode des Transistors T6 des ersten Stromverstärkers 40 und der Spannungsquelle +V eingeschaltet, während ein zweiter, im wesentlichen identischer PNP-Transistor T9 zwischen der Basis des Transistors T7 des zweiten Stromverstärkers 42 und der Spannungsquelle +V eingeschaltet ist. Ein erster Schalter 44 mit einem PNP-Transistor T10 ist mit seiner Emitterelektrode an der Spannungsquelle +V angeschlossen, eine Schottky-Diode D3 ist zwischen der Kollektorelektrode des PNP-Transistors T10 und der Basiselektrode des PNP-Transistors T8 eingeschaltet und eine Schottky-Diode D5 ist zwischen der Basiselektrode und der Kollektorelektrode des PNP-Transistors 10 eingeschaltet. Ein zweiter Schalter 46 enthält einen PNP-Transistor T11, der mit seiner Emitterelektrode an der Spannungsquelle +V angeschlossen ist, eine Schottky-Diode D4, die zwischen der Kollektorelektrode des PNP-Transistors T11 und der Basiselektrode des PNP-Transistors T9 eingeschaltet ist und eine Schottky-Diode D6, die zwischen der Basiselektrode und der Kollektorelektrode des PNP-Transistors T11 eingeschaltet ist. Eine Eingangsschaltung 48 enthält die Transistoren T12 und T14, die als Stromübernahmeschalter geschaltet sind, wobei die Basiselektrode des Transistors T14 an eine Bezugsspannungsquelle $V_{BEZ}$ angeschlossen ist, während die Kollektorelektrode an der Vorspannungsquelle +V angeschlossen und die Basiselektrode des Transistors T12 mit der Eingangsklemme und die Kollektorelektrode an der Kollektorelektrode des PNP-Transistors T10 des ersten Schalters 44 angeschlossen ist. Ein praktisch mit dem Transistor T12 identischer Transistor T13 ist mit seiner Basiselektrode an der Bezugsspannungsquelle $V_{BEZ}$ angeschlossen und seine Kollektorelektrode ist mit der Kollektorelektrode des PNP-Transistors T11 des zweiten Schalters 46 verbunden, so dass an den Kollektorelektroden beider Transistoren T12 und T13 gleich grosse Ströme auftreten, wenn die Eingangsklemme aufgetastet ist.

Eine Stromquelle 52 enthält die Transistoren T15, T16, T17 und T18, die mit ihren Emitterelektroden über Widerstände R15, R16, R17 bzw. R18 mit Masse verbunden sind, während an der Basiselektrode jedes der Transistoren T15, T16, T17 und T18 eine Bezugsstromquelle $V_R$ angeschlossen ist. Die Eingangsschaltung ist mit der Kollektorelektrode des Transistors T15 verbunden, die Verriegelungsschaltung 36 ist mit der Bezugsstromquelle 52 an der Kollektorelektrode des Transistors T16 verbunden, der Differentialverstärker 38 ist mit der Kollektorelektrode des Transistors T17 der Bezugsstromquelle 52 verbunden, und der Transistor T13 ist mit der Bezugsstromquelle 52 an der Kollektorelektrode des Transistors T18 verbunden.

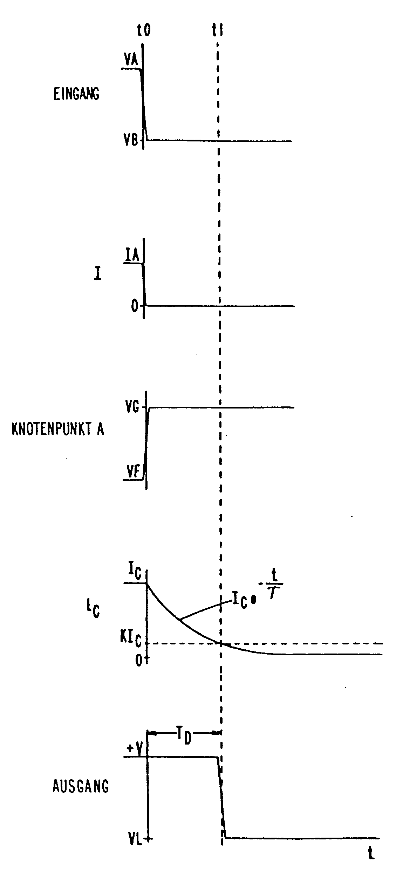

Die Arbeitsweise der integrierten Verzögerungsschaltung der Fig. 4 lässt sich wohl am besten anhand der Strom- und Spannungsverläufe der Fig. 5 verstehen. Wenn am Eingang eine positive Spannung $V_A$ liegt, dann fliesst ein Strom $I_A$ durch den Transistor T12, wobei am Knotenpunkt A die Spannung $V_f = +V-(V_{BE}+V_{SF})$ ist. Dabei ist +V die Spannung der Vorspannungsquelle +V, $V_{Be}$ ist die Basisemitterspannung jedes der gleichartig aufgebauten PNP-Transistoren T8 und T10 und $V_{SF}$ ist der Spannungsabfall in Durchlassrichtung über jeder der Schottky-Dioden D3 und D5. Unter diesen Bedingungen ist der an der Kollektorelektrode des PNP-Transistors T8 auftretende Strom = $i_C$. Der an der Kollektorelektrode des Transistors T6 fliessende Strom ist wegen der spiegelbildlichen Wirkung durch die Kombination der PNP-Transistoren T8 und T10 und der Schottky-Dioden D3 und D5 und der Verstärkung durch den Transistor T6 mit der Diode D1 dem Strom $I_A$ direkt proportional. Schaltungen mit spiegelbildlichem Betriebsverhalten sind bekannt und beispielsweise in der US-Patentschrift Nr. 4013898 beschrieben. An der Basis des Transistors T4 des Differentialverstärkers 38 bildet sich eine Spannung von $+V -I \cdot R6$, wobei $I \cdot R6$ der Spannungsabfall über dem Widerstand R6 ist. Wenn an der Kollektorelektrode des Transistors T13 ein Strom fliesst, dann liegt die Basiselektrode des Transistors T5 auf einer Spannung +V minus dem Spannungsabfall über R5 und die Ausgangsspannung an den Kollektoren der Transistoren T2 und T3 der Verriegelungsschaltung 36 ist auf ihrem hohen Wert +V.

Wird die Eingangsspannung auf einen negativeren Wert. $V_B$ umgeschaltet, dann geht der Strom $I_A$ auf den Transistor T14 der Eingangsschaltung 48 über, wobei der an der Kollektorelektrode des Transistors T12 fliessende Strom auf 0 abfällt, und die Spannung am Knotenpunkt A auf VG zunimmt, das gleich $+V-V_{SAT}$, ist, wenn $V_{SAT}$ die Spannung über dem Transistor T10 ist sowie der durch den Transistor 12 fliessende Strom gleich 0 ist. Wie aus Fig. 5 zu erkennen, beginnt der Strom $i_C$ an der Kollektorelektrode des Transistors T8 nunmehr wegen der Abnahme der in der Basiszone des Transistors T8 gespeicherten Ladung exponentiell abzunehmen, wie dies zuvor im Zusammenhang mit der im Transistor 10 in Fig. 1 und 2 gespeicherten Ladung besprochen worden war. Die exponentielle Abnahme des Stromes $i_C$ entspricht dabei der oben beschriebenen Abnahme und ist gleich $i_C \cdot e^{-t/\tau}$.

Es sei darauf hingewiesen, dass diese exponentielle Abnahme des Stromes durch den Schalter 44 mit den Schottky-Dioden D3 und D5 und dem Transistor T10 verursacht wird. Die Schottky-Dioden haben praktisch keine gespeicherte Ladung und eine sehr kleine Kapazität des Schichtübergangs. Wenn die Spannung am Knotenpunkt A auf $+V-V_{SAT}$ angehoben und die Schottky-Diode D3 in Sperrichtung vorgespannt ist, dann wird nur ein geringer Prozentsatz der in der Basiszone des PNP-Transistors T8 gespeicherten Ladung abgeleitet. Somit wird der ursprünglich im Transistor T8 fliessende Emitterstrom nur ganz geringfügig verringert. Ausserdem liefert die im Transistor T10 abgespeicherte Ladung die für einen schnellen Spannungsanstieg am Knotenpunkt A erforderliche Ansteuerung, wobei der Knotenpunkt A nur eine kleine Streukapazität C1 aufweist, so dass die Diode D3 sehr schnell in Sperrichtung vorgespannt wird. Die Verwendung von Schottky-Sperrschicht-Dioden als Elemente hoher Impedanz und als selbstsperrende Schalter ist aus dem Stand der Technik, wie z.B. den US-Patentschriften Nrn. 3585412 und 3701119 bekannt.

Durch die Kombination von Diode D1 und Transistor T6 wird an der Kollektorelektrode des Transistors T8 eine konstante Spannung angelegt. Diese konstante Spannung ist erwünscht, denn sie verhindert, dass das exponentielle Verhalten des NPN-Transistors T8 durch eine Ladungsübertragung über die Kapazität des Kollektor-Basisübergangs des PNP-Transistors T8 verändert wird. Die Zeitkonstante der Kombination aus Diode D1 und Transistor T6 ist sehr klein, verglichen mit der PNP-Zeitkonstante des Transistors T8 und somit ist die Zeitkonstante des Kollektorstromes des Transistors T6 die gleiche, wie die PNP-Zeitkonstante des Transistors T8. Die Spannung an der Basiselektrode des Transistors T4 ist eine Funktion der Zeit und ist

$$+ V - I \cdot R6 \, e^{\frac{\beta_{PNP} + 1}{\omega_{T_{PNP}}} t,}$$

wobei $\beta_{PNP}$ die Stromverstärkung und $\omega_{T_{PNP}} = 2\pi f_T$ des Transistors T8, und t die Zeit ist.

Die Kombination der PNP-Transistoren T9 und T11 und der Schottky-Dioden D4 und D6 ist praktisch identisch mit den PNP-Transistoren T8 und T10 und den Schottky-Dioden D3 und D5 mit gleichem Betriebsverhalten der beiden Kombinationen.

Die Ausgangsspannung der Schaltung wird dann negativ, wenn die Verriegelungsschaltung 36, wie dies in Fig. 5 dargestellt ist, zum Zeitpunkt t1 nach einer Verzögerungszeit $T_d$ umgeschaltet wird, und dieses Umschalten findet dann statt, wenn die Basiselektroden der Transistoren T4 und T5 auf gleichem Potential liegen, was durch das Verhältnis R6/R7 und die PNP-Abschaltzeitkonstante des Transistors T8 $(\beta_{PNP} + 1)/\omega_{T_{PNP}}$ bestimmt ist und wenn der Strom $i_C = KI_C$ ist, und K bezogen auf das Verhältnis der Widerstände R6 und R7.

Man sieht, dass die integrierte Verzögerungsschaltung gemäss der Erfindung den Vorteil aufweist, dass sie eine lange, genau steuerbare zeitliche Verzögerung auf einem mit integrierter Schaltung versehenen Substrat oder Halbleiterplättchen innerhalb eines kleinen Bereiches und bei geringer Leistung zu liefern vermag. Im wesentlichen der einzige Verfahrensparameter, der die durch das Verhältnis R6/R7 gewählte Verzögerungszeit $T_D$ beeinflussen, ist das Verhältnis $\beta/f_T$ des lateralen PNP-Transistors T8. Es sei darauf hingewiesen, dass die Verzögerungszeit

$$T_D = \frac{\beta_{PNP} + 1}{\omega_{T_{PNP}}} \cdot \ln \frac{R6}{R7} \text{ ist.}$$

Es ist fernerhin darauf verwiesen, dass diese Verzögerungsschaltung sich besonders für den Einsatz in dynamischen bipolaren Speicherschaltungen eignet, wo eine genaue Festlegung der PNP-Zeitkonstante erwünscht ist, d.h. wenn Verzögerungen bei der Einstellung einer Verriegelungsschaltung von 50 ns oder mehr erforderlich sind, nachdem ein Halbleiterplättchen eines Speichersystems ausgewählt worden ist.

Ferner sei darauf verwiesen, dass zwar im vorliegenden Fall PNP-Transistoren als Verzögerungselemente in der erfindungsgemäss aufgebauten Schaltung offenbart worden sind, dass ebensogut auch NPN-Transistoren eingesetzt werden können, dass sie jedoch wegen der Ladungsspeichereigenschaften von NPN-Transistoren kürzere Verzögerungszeiten liefern. Unabhängig davon, welche Art von Transistor als Verzögerungselement benutzt wird, sollte doch der an der Basis des Transistors angeschlossene Schalter eine wesentlich geringere Ladungsspeicherkapazität besitzen, als der zu steuernde Transistor.

**Patentansprüche:**

1. Integrierte Verzögerungsschaltung mit einem in seiner Basiszone (B) eine vorgegebene Ladungsspeicherkapazität aufweisenden bipolaren Transistor (10; T8; T9) dadurch gekennzeichnet, dass dessen Basiselektrode mit einem eine wesentlich geringere Ladungsspeicherkapazität aufweisenden elektronischen Schalter (T10, D3, D5, T11, D4, D6, 44, 46) verbunden ist, der den Stromfluss durch den Transistor (10; T8, T9) zu steuern vermag und dass eine auf eine vorbestimmte Amplitude dieses Stromes ansprechende Schwellenwert-Schaltung (36, 38, 40, 42) vorgesehen ist, und dass im geschlossenen Zustand des elektronischen Schalters (D3, D4) der den Transistor (10, T8, T9) durchfliessende Strom im stationären Zustand aufrechterhalten wird, und bei geöffnetem Schalter exponentiell abnimmt.

2. Verzögerungsschaltung nach Anspruch 1, dadurch gekennzeichnet, dass der Transistor (10; T8, T9) ein bipolarer lateraler PNP-Transistor ist.

3. Verzögerungsschaltung nach Anspruch 1, dadurch gekennzeichnet, dass der elektronische Schalter (44, 46) als elektronischen Schaltkontakt eine Schottky-Sperrschicht-Diode (D3, D4) enthält.

4. Verzögerungsschaltung nach Anspruch 1, dadurch gekennzeichnet, dass der elektronische Schalter (44, 46) eine Spannungsquelle (+V) und einen zweiten Transistor (T10, T11) enthält, der zwischen die Spannungsquelle (+V) und den elektronischen Schaltkontakt (D3, D4) eingekoppelt ist.

5. Verzögerungsschaltung nach Anspruch 4, dadurch gekennzeichnet, dass der elektronische Schalter eine erste Schottky-Diode (D5, D6) enthält, die zwischen Basis- und Kollektorelektrode des zweiten Transistors (T10, T11) eingeschaltet ist, dass der zweite Transistor ein PNP-Transistor ist und dass der elektronische Schaltkontakt ebenfalls eine Schottky-Diode (D3, D4) ist.

6. Verzögerungsschaltung nach Anspruch 5, dadurch gekennzeichnet, dass der bipolare Transistor (T8, T9) und der zweite Transistor (T10, T11) beide emitterseitig an der Spannungsquelle (+V) angeschlossen sind, dass die beiden Schottky-Dioden (D3, D5, D4, D6) mit ihren Kathoden an einem gemeinsamen Punkt (A) angeschlossen sind, und dass der elektronische Schalter eine an diesem gemeinsamen Punkt (A) angeschlossene Impulsquelle (T12, T14) enthält.

7. Verzögerungsschaltung nach den Ansprüchen 1-6, dadurch gekennzeichnet, dass eine Vergleichsstufe (T4, T5, R4, R5) mit zwei Eingängen und einem Ausgang vorgesehen ist, dass dabei der bipolare Transistor (T8, T9) zwischen der Spannungsquelle (+V) und dem ersten Eingang (Basis von T4) eingeschaltet ist, und dass eine Bezugsstromquelle (T13; T14) zwischen der Spannungsquelle (+V) und dem zweiten Eingang (Basis von T5) eingeschaltet ist.

8. Verzögerungsschaltung nach Anspruch 7, dadurch gekennzeichnet, dass die Vergleichsstufe eine Verriegelungsschaltung (26; T1, T2, T3) enthält, die am Ausgang eines Differentialverstärkers (T4, T5) angeschlossen ist, deren Eingänge je über eine Stromverstärkerstufe (40, 42; T6, D1, T7, D2) ansteuerbar sind, dass dabei der Eingang der ersten Stromverstärkerstufe aus der Kollektorelektrode des bipolaren Transistors (T8, T9) angeschlossen ist, und dass die zweite Stromverstärkerstufe (T7, D2) mit der Bezugsstromquelle (T13) verbunden ist.

## Revendications

1. Circuit à retard intégré comportant un transistor bipolaire (10; T8, T9) ayant dans sa zone de base (B) une capacité d'emmagasinage de charge prédéterminée, caractérisé en ce que l'électrode de base dudit transistor est reliée à un commutateur électronique (T10, D3, D5, T11, D4, D6, 44, 46) dont la capacité d'emmagasinage porteur de charge est nettement plus faible, et qui peut commander l'écoulement de courant à travers ledit transistor (10; T8, T9), et en ce qu'il est prévu un circuit à seuil (36, 38, 40, 42) correspondant à une amplitude prédéterminée dudit courant, et en ce que ledit courant passant à travers ledit transistor (10; T8, T9) est maintenu à l'état stationnaire quand le commutateur électronique (D3, D4) est fermé, alors qu'il décroît de façon exponentielle quand le commutateur est ouvert.

2. Circuit à retard selon la revendication 1, caractérisé en ce que ledit transistor (10; T8, T9) est un transistor PNP bipolaire latéral.

3. Circuit à retard selon la revendication 1, caractérisé en ce que ledit commutateur électronique (44, 46) comprend une diode à barrière de Schottky (D3, D4) faisant fonction de contact de commutation électronique.

4. Circuit à retard selon la revendication 1, caractérisé en ce que le commutateur électronique (44, 46) comprend une source de tension de polarisation (+V) et un second transistor (T10, T11) qui est intercalé entre la source de tension de polarisation (+V) et le contact de commutation électronique (D3, D4).

5. Circuit à retard selon la revendication 4, caractérisé en ce que le commutateur électronique comprend une première diode de Schottky (D5, D6) qui est intercalée entre l'électrode de base et l'électrode de collecteur dudit second transistor (T10, T11), en ce que ledit second transistor est un transistor PNP, et en ce que le contact de commutation électronique est également une diode de Schottky (D3, D4).

6. Circuit à retard selon la revendication 5, caractérisé en ce que ledit transistor bipolaire (T8, T9) ainsi que ledit second transistor (T10, T11) sont tous les deux connectés du côté de leur émetteur à ladite source de tension de polarisation (+V), en ce que les deux dites diodes de Schottky (D3, D5, D4, D6) sont connectées par leurs cathodes à un point commun (A), et en ce que ledit commutateur électronique comprend une source d'impulsions (T12, T14) reliée audit point commun (A).

7. Circuit à retard selon l'une quelconque des revendications 1 à 6, caractérisé en ce qu'un étage de comparaison (T4, T5, R4, R5) comporte deux entrées et une sortie, en ce que ledit transistor bipolaire (T8, T9) est intercalé entre ladite source de tension de polarisation (+V) et la première entrée (base de T4), et en ce qu'une source de courant de référence (T13, T14) est intercalée entre ladite source de tension de polarisation (+V) et ladite seconde entrée (base de T5).

8. Circuit à retard selon la revendication 7, caractérisé en ce que ledit étage de comparaison comprend une bascule de verrouillage (26; T1, T2, T3) qui est reliée à la sortie d'un amplificateur différentiel (T4, T5) dont chacune des entrées peut être commandée *via* un étage d'amplification de courant (40, 42; T6, D1, T7, D2), en ce que l'entrée dudit premier étage d'amplification de courant est reliée à l'électrode de collecteur dudit transistor bipolaire (T8, T9), et en ce que ledit second étage d'amplification de courant (T7, D2) est reliée à ladite source de courant de référence (T13).

## Claims

1. Integrated delay circuit comprising a bipolar transistor (10; T8, T9) having in its base region (B) a predetermined charge storage capacity, characterized in that the base electrode thereof is connected to an electronic switch (T10, D3, D5, T11, D4, D6, 44, 46) having a much lower charge storage capacity and being able to control the current flow through the transistor (10; T8, T9), and that a threshold circuit (36, 38, 40, 42) responsive to a predetermined amplitude of this current is provided, and that in the closed condition of the electronic switch (D3, D4) the current flowing through the transistor (10; T8, T9) is maintained in the stationary state, and decreases exponentially if the switch is in the open condition.

2. Delay circuit as claimed in claim 1, characterized in that the transistor (10; T8, T9) is a bipolar lateral PNP transistor.

3. Delay circuit as claimed in claim 1, characterized in that the electronic switch (44, 46) contains as electronic switching contact a Schottky barrier layer diode (D3, D4).

4. Delay circuit as claimed in claim 1, characterized in that the electronic switch (44, 46) contains a voltage source (+V) and a second transistor (T10, T11) coupled between the voltage source (+V) and the electronic switching contact (D3, D4).

5. Delay circuit as claimed in claim 4, characterized in that the electronic switch contains a first Schottky diode (D5, D6) connected between base and collector electrode of the second transistor (T10, T11), that the second transistor is a PNP transistor, and that the electronic switching contact is also a Schottky diode (D3, D4).

6. Delay circuit as claimed in claim 5, characterized in that the emitter contacts of both the bipolar transistor (T8, T9) and the second transistor (T10, T11) are connected to the voltage source (+V), that the two Schottky diodes (D3, D5, D4, D6) are connected with their cathodes to a common point (A), and that the electronic switch contains a pulse source (T12, T14) connected at this common point (A).

7. Delay circuit as claimed in any one of claims 1 to 6, characterized in that a comparator stage (T4, T5, R4, R5) with two inputs and one output is provided, that the bipolar transistor (T8, T9) is connected between the voltage source (+V) and the first input (base of T4), and that a reference current source (T13, T14) is connected between the voltage source (+V) and the second input (base of T5).

8. Delay circuit as claimed in claim 7, characterized in that the comparator contains a latch (26; T1, T2, T3) which is connected at the output of a differential amplifier (T4, T5) and whose inputs are controllable each via a current amplifier (40, 42; T6, D1, T7, D2), that the input of the first current amplifier is connected to the collector electrode of the bipolar transistor (T8, T9), and that the second current amplifier (T7, D2) is connected to the reference current source (T13).

FIG. 1

FIG. 2

FIG. 3

9

FIG. 4

EINGANG

$V_A$

$V_B$

$t0$     $t1$

I

$I_A$

$0$

KNOTENPUNKT A

$V_G$

$V_F$

$I_C$

$I_C$

$I_C \cdot e^{-\frac{t}{T}}$

$K I_C$

$0$

AUSGANG

$T_D$

$+V$

$V_L$

$t$